# EUROPÄISCHE PATENTSCHRIFT

(11) **EP 2 843 315 B1**
(45) Veröffentlichungstag und Bekanntmachung des Hinweises auf die Patenterteilung: **24.02.2021**
(21) Anmeldenummer: 14178738.2
(22) Anmeldetag: 28.07.2014
(51) Int. Cl.: F24C 7/08

(54) **System zu einer Zusammenstellung zumindest einer Hausgerätevorrichtung und Hausgerätevorrichtung**
Method for putting together at least one domestic appliance and domestic appliance
Système destiné à assembler au moins un dispositif d'appareil ménager et un appareil ménager

(30) Priorität: 31.07.2013 ES 201331185
(43) Veröffentlichungstag der Anmeldung: 04.03.2015
(73) Patentinhaber: BSH Hausgeräte GmbH, 81739 München (DE)
(72) Erfinder: Arnal Valero, Adolfo, 50009 Zaragoza (ES); Martin Gomez, Damaso, 20012 Zaragoza (ES); Pina Gadea, Carmelo, 50008 Zaragoza (ES); Torrubia Marco, Demetrio, 50003 Zaragoza (ES)

(56) Entgegenhaltungen:
- EP-A1- 1 732 224
- EP-A1- 2 578 948
- EP-A2- 0 687 131
- EP-A2- 1 651 022
- WO-A2-2012/089543
- DE-A1-102009 045 665
- DE-A1-102012 209 456
- DE-U1- 9 112 371
- DE-U1- 20 319 489

## Beschreibung

Die Erfindung geht aus von einem System zu einer Zusammenstellung zumindest einer Hausgerätevorrichtung nach dem Oberbegriff des Anspruchs 1.

Es ist bereits ein System zu einer Zusammenstellung zumindest einer Hausgerätevorrichtung, insbesondere einer Kochfeldvorrichtung, das zumindest einen Grundkörper, zumindest eine erste Touch-Bedieneinheit eines ersten Typs und zumindest eine zweite Touch-Bedieneinheit eines zweiten Typs aufweist, wobei zumindest in montiertem Zustand zumindest eine der Touch-Bedieneinheiten von dem Grundkörper gehalten ist, vorgeschlagen worden.

Die EP 2 578 948 A1 offenbart ein Kochfeld mit einem Grundkörper und mit einer Touch-Bedieneinheit, die in einem montierten Zustand auf dem Grundkörper aufliegt und durch ein Federelement gegen eine Unterseite einer Kochfeldplatte gedrückt wird.

Aus der DE 91 12 371 U1 ist ein Kochfeld bekannt, mit einem Grundkörper und mit einer Touch-Bedieneinheit, die in einem montierten Zustand durch Federelemente beabstandet zu dem Grundkörper angeordnet ist und durch die Federelemente gegen eine Unterseite einer Kochfeldplatte gedrückt wird.

Die EP 1 651 022 A2 zeigt einen Halter zur Lagerung eines Bauteilträgers mit auf dem Halter verteilt angeordneten Federelementen, wobei die Federelemente einstückig mit einem Grundkörper des Halters ausgebildet sind.

Die DE 203 19 489 U1 offenbart ein explosionsgeschütztes Gehäuse, innerhalb dessen eine Touch-Bedieneinheit durch Federelemente an ein Sichtfenster gepresst angeordnet ist.

Die EP 1 732 224 A1 offenbart eine Touch-Bedieneinheit, die in einem montierten Zustand durch Federelemente beabstandet zu einem Grundkörper angeordnet ist.

Die WO 2012/089543 A2 offenbart die Merkmale des Oberbegriffes, nämlich ein System zu einer Zusammenstellung zumindest einer Kochfeldvorrichtung, welches zumindest einen Grundkörper, zumindest eine erste Touch-Bedieneinheit einer ersten Größe und zumindest eine zweite Touch-Bedieneinheit einer zweiten Größe aufweist, wobei zumindest in montiertem Zustand zumindest eine der Touch-Bedieneinheiten von dem Grundkörper gehalten ist.

Die Aufgabe der Erfindung besteht insbesondere darin, ein System zu einer Zusammenstellung zumindest einer gattungsgemäßen Hausgerätevorrichtung mit verbesserten Eigenschaften hinsichtlich einer preiswerten Ausgestaltung bereitzustellen. Die Aufgabe wird erfindungsgemäß durch die Merkmale des Patentanspruchs 1 gelöst, während vorteilhafte Ausgestaltungen und Weiterbildungen der Erfindung den Unteransprüchen entnommen werden können.

Die Erfindung geht aus von einem System zu einer Zusammenstellung, insbesondere zu einer Herstellung, zumindest einer Hausgerätevorrichtung, insbesondere einer Kochfeldvorrichtung, das zumindest einen Grundkörper, zumindest eine erste Touch-Bedieneinheit eines ersten Typs und zumindest eine zweite Touch-Bedieneinheit eines zweiten Typs aufweist, wobei zumindest in montiertem Zustand zumindest eine der Touch-Bedieneinheiten von dem Grundkörper gehalten ist.

Es wird vorgeschlagen, dass der Grundkörper dazu vorgesehen ist, in Abhängigkeit von einem Typ der von dem Grundkörper gehaltenen Touch-Bedieneinheit die Touch-Bedieneinheit unterschiedlich hart zu federn. Unter einem "Grundkörper" soll insbesondere eine Einheit verstanden werden, die dazu vorgesehen ist, zumindest einen Großteil einer Gewichtskraft zumindest einer der Touch-Bedieneinheiten aufzunehmen und/oder zumindest eine der Touch-Bedieneinheiten in zumindest einer festgelegten Position zu halten. Insbesondere ist der Grundkörper dazu vorgesehen, die aufgenommene Gewichtskraft der Touch-Bedieneinheit an zumindest eine weitere Einheit, insbesondere an zumindest ein Außengehäuse, abzuleiten. Insbesondere weist der Grundkörper ein Volumen von weniger als 200 x 90 x 40 mm³, insbesondere von weniger als 180 x 80 x 35 mm³ und vorteilhaft von weniger als 170 x 75 x 30 mm³ auf. Insbesondere weist der Grundkörper ein Volumen von mehr als 120 x 50 x 10 mm³, insbesondere von mehr als 150 x 60 x 15 mm³ und vorteilhaft von mehr als 160 x 65 x 20 mm³ auf. Insbesondere ist der Grundkörper aus Kunststoff, beispielsweise aus Polypropylen, ausgebildet. Alternativ sind weitere, einem Fachmann als sinnvoll erscheinende Materialien denkbar. Unter einer "Touch-Bedieneinheit" soll insbesondere eine Einheit mit zumindest einem berührungsempfindlichen Bedienelement verstanden werden. Insbesondere weist die Touch-Bedieneinheit zumindest 2, insbesondere zumindest 4, vorteilhaft zumindest 6, besonders vorteilhaft zumindest 9 bevorzugt zumindest 12 und besonders bevorzugt zumindest 15 berührungsempfindliche Bedienelemente auf. Insbesondere ist die Touch-Bedieneinheit in montiertem Zustand unterhalb einer Berührungsfläche angeordnet. Unter einem "berührungsempfindlichen Bedienelement" soll insbesondere ein Element verstanden werden, das dazu vorgesehen ist, auf eine Berührung und/oder eine Annäherung durch einen Bediener, insbesondere eine Annäherung eines Körperteils, beispielsweise eines Fingers, eines Bedieners, insbesondere innerhalb eines Abstands von maximal 10 cm, insbesondere maximal 3 cm, vorteilhaft maximal 1 cm, vorzugsweise maximal 0,5 cm, zu reagieren. Insbesondere reagiert das berührungsempfindliche Bedienelement auf eine Annäherung unabhängig von einer direkten Berührung und/oder Druckausübung, insbesondere durch die Berührungsfläche hindurch. Insbesondere ist die Berührungsfläche als eine Glas- und/oder Kunststoffeinheit und/oder eine Kochfeldplatte ausgebildet. Insbesondere ist die Touch-Bedieneinheit dazu vorgesehen, ein durch eine Betätigung von dem berührungsempfindlichen Bedienelement detektiertes Bediensignal an zumindest eine Steuereinheit der Hausgerätevorrichtung zu übertragen. Unter einer Touch-Bedieneinheit eines "ersten Typs" und einer Touch-Bedieneinheit eines "zweiten Typs" sollen zwei Touch-Bedieneinheiten verstanden werden, die sich in zumindest einem Merkmal, und zwar in zumindest einer Ausgestaltung des berührungsempfindlichen Bedienelements und insbesondere in zumindest einem Gewicht und/oder in zumindest einer Höhe, voneinander unterscheiden. Es sind verschiedene, einem Fachmann als sinnvoll erscheinende Ausbildungen des berührungsempfindlichen Bedienelements denkbar. Beispielsweise könnte das berührungsempfindliche Bedienelement als ein resistiver Sensor und/oder als ein induktiver Sensor und/oder als ein schallwellengesteuerter Sensor ausgebildet sein. Erfindungsgemäß ist zumindest ein Teil der berührungsempfindlichen Bedienelemente als Infrarotsensor ausgebildet. Erfindungsgemäß ist zumindest ein Teil der berührungsempfindlichen Bedienelemente als kapazitiver Sensor ausgebildet. Unter einem "Infrarotsensor" soll insbesondere ein berührungsempfindliches Bedienelement verstanden werden, das dazu vorgesehen ist, zumindest eine einfallende Infrarotstrahlung, insbesondere aus einem Wellenlängenbereich von 780 nm bis 1 mm, in zumindest ein elektrisches Signal umzuwandeln. Unter einem "kapazitiven Sensor" soll insbesondere ein berührungsempfindliches Bedienelement mit zumindest einer Elektrode verstanden werden, das dazu vorgesehen ist, eine Kapazität der Elektrode, die sich bei einer Annäherung verändert, auszuwerten. Insbesondere ist der kapazitive Sensor dazu vorgesehen, bei einer Annäherung und/oder Berührung zumindest eine Änderung eines elektrischen Felds zu detektieren und/oder zumindest einen Ladungstransport hervorzurufen, der insbesondere proportional zu einem von dem berührungsempfindlichen Bedienelement detektierten Bediensignal ist. Insbesondere müssen kapazitive Sensoren mit einer insbesondere hohen Kraft gegen zumindest eine Berührungsfläche, insbesondere eine Bedienfläche, gepresst werden, um eine Funktionsfähigkeit sicherzustellen. Unter der Wendung, dass zumindest in montiertem Zustand zumindest eine der Touch-Bedieneinheiten von dem Grundkörper "gehalten" ist, soll insbesondere verstanden werden, dass der Grundkörper in montiertem Zustand zumindest einen Großteil einer Gewichtskraft der Touch-Bedieneinheit aufnimmt und/oder die Touch-Bedieneinheit in zumindest einer festgelegten Position hält. Unter der Wendung, dass der Grundkörper dazu vorgesehen ist, in Abhängigkeit von einem Typ der von dem Grundkörper gehaltenen Touch-Bedieneinheit die Touch-Bedieneinheit "unterschiedlich hart" zu federn, soll verstanden werden, dass der Grundkörper dazu vorgesehen ist, die erste Touch-Bedieneinheit des ersten Typs mit einer ersten Federkonstanten bezüglich des Grundkörpers zu lagern und die zweite Touch-Bedieneinheit des zweiten Typs mit einer zweiten Federkonstanten, die größer als die erste Federkonstante ist, bezüglich des Grundkörpers zu lagern. Insbesondere ist der Grundkörper dazu vorgesehen, die erste Touch-Bedieneinheit des ersten Typs mit einer Federkonstanten von weniger als 1000 N/m, insbesondere von weniger als 600 N/m und vorteilhaft von weniger als 400 N/m zu lagern. Insbesondere ist der Grundkörper dazu vorgesehen, die zweite Touch-Bedieneinheit des zweiten Typs mit einer Federkonstanten von mehr als 1000 N/m, insbesondere von mehr als 10.000 N/m, vorteilhaft von mehr als 20.000 N/m, vorzugsweise von mehr als 50.000 N/m und insbesondere von mehr als 100.000 N/m zu lagern. Insbesondere ist der Grundkörper dazu vorgesehen, die erste Touch-Bedieneinheit des ersten Typs federnd bezüglich des Grundkörpers zu lagern und die zweite Touch-Bedieneinheit des zweiten Typs ungefedert bezüglich des Grundkörpers zu lagern. Insbesondere ist eine von dem Grundkörper aufzubringende Federkraft zumindest der zweiten Touch-Bedieneinheit abhängig von einer Anzahl an berührungsempfindlichen Bedienelementen. Insbesondere erhöht sich die von dem Grundkörper aufzubringende Federkraft in Abhängigkeit der Anzahl an berührungsempfindlichen Bedienelementen, insbesondere für jedes berührungsempfindliche Bedienelement um 5 N plus/minus 1,5 N. Insbesondere ist eine Federkraft zu einem Halten der zweiten Touch-Bedieneinheit des zweiten Typs um einen Faktor 20, insbesondere um einen Faktor 40, vorteilhaft um einen Faktor 100 und vorzugsweise um einen Faktor 200 größer als eine Federkraft zu einem Halten der ersten Touch-Bedieneinheit des ersten Typs. Insbesondere weist die erste Touch-Bedieneinheit des ersten Typs eine zumindest im Wesentlichen von einer Anzahl an Sensorelementen unabhängige Masse auf. Insbesondere beträgt eine Masse der ersten Touch-Bedieneinheit des ersten Typs 25 g plus/minus 7 g. Insbesondere weist die zweite Touch-Bedieneinheit des zweiten Typs eine von einer Anzahl an Sensorelementen abhängige Masse auf. Insbesondere beträgt eine Masse der ersten Touch-Bedieneinheit des zweiten Typs 50 g plus/minus 15 g. Unter "vorgesehen" soll insbesondere speziell ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Durch die erfindungsgemäße Ausgestaltung kann insbesondere eine preiswerte Ausgestaltung erreicht werden. Insbesondere können geringe Lagerkosten und/oder geringe Logistikkosten erreicht werden. Zudem kann eine flexible Lagerung der beiden Touch-Bedieneinheiten erreicht werden. Insbesondere kann vorteilhaft für unterschiedliche Typen von Touch-Bedieneinheiten der gleiche Grundkörper verwendet werden, wodurch eine preiswerte Ausgestaltung erreicht werden kann. Durch eine unterschiedlich harte Federung können vorteilhaft in Abhängigkeit eines Typs von Touch-Bedieneinheiten unterschiedliche Positionen relativ zu dem Grundkörper und/oder relativ zu der Berührungsfläche erreicht werden. Zudem kann vorteilhaft ein Abstand einer der Touch-Bedieneinheiten von zumindest einer Platteneinheit in Abhängigkeit von einem Typ der Touch-Bedieneinheiten variieren, wodurch eine hohe Funktionsfähigkeit der Touch-Bedieneinheiten erreicht werden kann.

Eine von dem Grundkörper aufzubringende Kraft zu einem Halten der ersten Touch-Bedieneinheit ist zumindest um einen Faktor 20, insbesondere um einen Faktor 40, vorteilhaft um einen Faktor 100, vorzugsweise um einen Faktor 200, kleiner als eine von dem Grundkörper aufzubringende Kraft zu einem Halten der zweiten Touch-Bedieneinheit, insbesondere zu einem Pressen der zweiten Touch-Bedieneinheit gegen die Berührungsfläche der Platteneinheit. Dabei variiert die von dem Grundkörper aufzubringende Kraft in Abhängigkeit von einem Typ der aufgelegten Touch-Bedieneinheit zumindest um einen Faktor 20, insbesondere um einen Faktor 40, vorteilhaft um einen Faktor 100 und vorzugsweise um einen Faktor 200. Dadurch kann vorteilhaft eine flexible Ausgestaltung des Grundkörpers und/oder eine flexible Lagerung der Touch-Bedieneinheiten in Abhängigkeit von einem Typ erreicht werden.

Zudem wird vorgeschlagen, dass der Grundkörper zumindest ein Federelement aufweist, das dazu vorgesehen ist, zumindest in montiertem Zustand zumindest die erste Touch-Bedieneinheit federnd bezüglich dem Grundkörper zu lagern. Insbesondere stützt sich das Federelement auf zumindest einem Hauptkörper des Grundkörpers ab. Insbesondere liegt die erste Touch-Bedieneinheit in montiertem Zustand auf dem Federelement des Grundkörpers auf. Insbesondere weist die erste Touch-Bedieneinheit in montiertem Zustand einen Abstand von mehr als 1 mm, insbesondere von mehr als 3 mm, vorteilhaft von mehr als 5 mm und vorzugsweise von mehr als 7 mm von dem Hauptkörper, insbesondere von einer von dem Hauptkörper aufgespannten Hauptkörperebene, auf. Beispielsweise könnte das Federelement als ein getrennt von dem Hauptkörper des Grundkörpers ausgebildetes, sich auf dem Hauptkörper abstützendes Federelement ausgebildet sein. Insbesondere ist das Federelement einstückig an dem Grundkörper, insbesondere dem Hauptkörper des Grundkörpers, angebunden. Insbesondere ragt das Federelement in unbelastetem Zustand über eine Strecke von mehr als 5 mm, insbesondere von mehr als 7 mm, vorteilhaft von mehr als 10 mm und vorzugsweise von mehr als 12 mm über die Hauptkörperebene hinaus. Insbesondere ragt das Federelement in unbelastetem Zustand über eine Strecke von weniger als 30 mm, insbesondere von weniger als 25 mm und vorteilhaft von weniger als 20 mm über die Hauptkörperebene hinaus. Insbesondere ragt das Federelement in unbelastetem Zustand über eine Strecke von mehr als 2 mm, insbesondere von mehr als 5 mm und vorteilhaft von mehr als 7 mm über zumindest ein Abstandselement des Grundkörpers hinaus. Insbesondere ragt das Federelement in unbelastetem Zustand über eine Strecke von weniger als 25 mm, insbesondere von weniger als 20 mm und vorteilhaft von weniger als 15 mm über das Abstandselement hinaus. Insbesondere ist in montiertem Zustand zumindest eine der Touch-Bedieneinheiten auf den Grundkörper aufgelegt. Unter einem "Hauptkörper" des Grundkörpers soll insbesondere ein einstückig ausgebildeter, zusammenhängender Teil des Grundkörpers verstanden werden, dessen Teilbereiche unabhängig von einem Betriebszustand einen konstanten Abstand zu einem Schwerpunkt des Grundkörpers aufweisen. Insbesondere sind einzelne Teilbereiche des Hauptkörpers unbeweglich relativ zu dem Schwerpunkt des Grundkörpers angeordnet. Insbesondere umfasst der Hauptkörper einen Anteil von mehr als 50 %, insbesondere von mehr als 70 % und vorteilhaft von mehr als 80 % einer Masse des Grundkörpers. Insbesondere spannt der Hauptkörper in einer der Touch-Bedieneinheit zuweisenden Richtung zumindest eine Hauptkörperebene auf, die von einem Anteil von mehr als 50 %, insbesondere von mehr als 70 % und vorteilhaft von mehr als 80 % einer Oberfläche des Hauptkörpers in der der Touch-Bedieneinheit zuweisenden Richtung definiert ist. Unter "einstückig" soll insbesondere zumindest stoffschlüssig verbunden verstanden werden, beispielsweise durch einen Schweißprozess, einen Klebeprozess, einen Anspritzprozess und/oder einen anderen, dem Fachmann als sinnvoll erscheinenden Prozess, und/oder vorteilhaft in einem Stück geformt verstanden werden, wie beispielsweise durch eine Herstellung aus einem Guss und/oder durch eine Herstellung in einem Ein- oder Mehrkomponentenspritzverfahren und vorteilhaft aus einem einzelnen Rohling. Dadurch kann vorteilhaft eine geringe Fehlerquote der ersten Touch-Bedieneinheit bezüglich einer Detektion eines Bediensignals erreicht werden. Durch das einstückig an dem Grundkörper angebundene Federelement kann vorteilhaft eine preiswerte und/oder stabile Ausgestaltung der Hausgerätevorrichtung erreicht werden.

Weiterhin wird vorgeschlagen, dass der Grundkörper zumindest ein Abstandselement aufweist, das dazu vorgesehen ist, zumindest in montiertem Zustand eine Gewichtskraft, und vorteilhaft eine Anpresskraft, zumindest der zweiten Touch-Bedieneinheit zumindest größtenteils zu tragen. Insbesondere ist das Abstandselement von dem Federelement getrennt ausgebildet. Insbesondere sind das Federelement und das Abstandselement zwei verschiedene Elemente des Grundkörpers. Insbesondere ist das Abstandselement unbeweglich relativ zu dem Hauptkörper angeordnet. Insbesondere ist das Abstandselement einstückig an dem Grundkörper, insbesondere dem Hauptkörper des Grundkörpers, angebunden. Insbesondere ragt das Abstandselement in unbelastetem Zustand über eine Strecke von mehr als 1 mm, insbesondere von mehr als 3 mm und vorteilhaft von mehr als 4 mm über die Hauptkörperebene hinaus. Insbesondere ragt das Abstandselement in unbelastetem Zustand über eine Strecke von weniger als 20 mm, insbesondere von weniger als 15 mm, vorteilhaft von weniger als 10 mm und vorzugsweise von weniger als 7 mm über die Hauptkörperebene hinaus. Unter der Wendung, dass das Abstandselement dazu vorgesehen ist, zumindest in montiertem Zustand eine Gewichtskraft und eine Anpresskraft zumindest der zweiten Touch-Bedieneinheit "zumindest größtenteils" zu tragen, soll insbesondere verstanden werden, dass das Abstandselement dazu vorgesehen ist, zumindest in montiertem Zustand einen Anteil von mehr als 70 %, insbesondere von mehr als 80 % und vorteilhaft von mehr als 90 % der Gewichtskraft zumindest der zweiten Touch-Bedieneinheit zu tragen. Dadurch kann vorteilhaft die zweite Touch-Bedieneinheit in einer definierten Position gehalten werden. Zudem kann vorteilhaft eine geringe Fehlerquote der zweiten Touch-Bedieneinheit bezüglich einer Detektion eines Bediensignals erreicht werden.

Ferner wird vorgeschlagen, dass das Federelement zumindest in montiertem Zustand von der durch den Grundkörper gehaltenen zweiten Touch-Bedieneinheit bis auf eine Höhe des Abstandselements ausgelenkt ist. Insbesondere sind ein von der Hauptkörperebene maximal entfernter Punkt des Federelements und ein von der Hauptkörperebene maximal entfernter Punkt des Abstandselements in zumindest einer Ebene angeordnet, die zumindest im Wesentlichen parallel zu der Hauptkörperebene ausgerichtet ist. Insbesondere überragt das Federelement das Abstandselement zumindest in kraftlosem Zustand über eine Strecke von mehr als 1 mm, insbesondere von mehr als 3 mm, vorteilhaft von mehr als 4 mm und vorzugsweise von mehr als 7 mm. Insbesondere überragt das Federelement das Abstandselement zumindest in kraftlosem Zustand über eine Strecke von weniger als 20 mm, insbesondere von weniger als 15 mm und vorteilhaft von weniger als 12 mm. Unter der Wendung, dass eine Gerade und/oder Ebene "zumindest im Wesentlichen parallel" zu einer weiteren, von der einen Gerade und/oder Ebene getrennt ausgebildeten Geraden und/oder Ebene ausgerichtet ist, soll insbesondere verstanden werden, dass die Gerade und/oder Ebene mit der weiteren Geraden und/oder Ebene einen Winkel einschließt, der vorzugsweise um weniger als 15°, vorteilhaft um weniger als 10° und insbesondere um weniger als 5° von einem Winkel von 0° abweicht. Dadurch kann vorteilhaft ein flexibel an eine zu haltende Touch-Bedieneinheit anpassbarer Grundkörper erreicht werden.

Die erste Touch-Bedieneinheit weist zumindest einen Infrarotsensor auf. Dadurch kann vorteilhaft eine präzise Detektion eines Bediensignals erreicht werden.

Die zweite Touch-Bedieneinheit weist zumindest einen kapazitiven Sensor auf. Dadurch kann vorteilhaft eine funktionsfähige zweite Touch-Bedieneinheit erreicht werden.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Hausgerät mit einer Hausgerätevorrichtung in einer schematischen Draufsicht,
- Fig. 2: einen Grundkörper für ein erfindungsgemäßes System in unmontiertem Zustand in einer perspektivischen Darstellung,
- Fig. 3: den Grundkörper mit einer ersten Touch-Bedieneinheit in einem montierten Zustand in einer perspektivischen Darstellung,
- Fig. 4: den Grundkörper mit der ersten Touch-Bedieneinheit aus Fig. 3 in einem in einem Hausgerät eingebauten Zustand in einer Schnittdarstellung,
- Fig. 5: den Grundkörper mit einer zweiten Touch-Bedieneinheit in einem montierten Zustand in einer perspektivischen Darstellung und
- Fig. 6: den Grundkörper mit der zweiten Touch-Bedieneinheit aus Fig. 5 in einem in einem Hausgerät eingebauten Zustand in einer Schnittdarstellung.

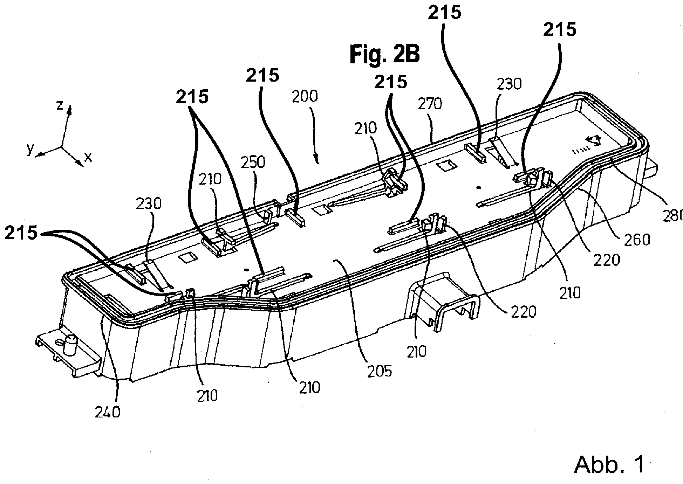

Fig. 1 zeigt ein Hausgerät 26, das als ein Kochfeld ausgebildet ist, mit einer Hausgerätevorrichtung 10, die als eine Kochfeldvorrichtung ausgebildet ist. Alternativ zu einer Ausbildung als Induktionskochfeld könnte das Hausgerät 26 als Backofen, Mikrowellengerät und/oder Grill ausgebildet sein. Ebenfalls denkbar sind weitere, einem Fachmann als sinnvoll erscheinende Hausgeräte. Die Hausgerätevorrichtung 10 weist eine Platteneinheit 28 zu einem Aufstellen von Gargeschirren auf. Die Platteneinheit 28 ist als eine Kochfeldplatte ausgebildet. Die Hausgerätevorrichtung 10 weist vier Heizeinheiten 30 auf, die als Induktionsheizeinheiten ausgebildet sind. Die Heizeinheiten 30 sind unterhalb der Platteneinheit 28 angeordnet. Die Heizeinheiten 30 sind jeweils dazu vorgesehen, ein auf der Platteneinheit 28 oberhalb einer der Heizeinheiten 30 aufgestelltes Gargeschirr zu erhitzen. Jede der Heizeinheiten 30 ist im Wesentlichen kreisförmig ausgebildet und bildet eine eigenständige Heizzone zu einem Erhitzen eines aufgestellten Gargeschirrs aus. Die Platteneinheit 28 weist in einem in eingebautem Zustand einem Bediener zuweisenden Bereich eine Berührungsfläche 32 auf, über welche durch eine Berührung der Berührungsfläche 32 Steuerungssignale zu einer Steuerung eines Betriebs eingebbar sind. Beispielsweise sind die Steuerungssignale als Auswahl und/oder Veränderung einer Heizzone und/oder als eine Einstellung einer Heizleistung und/oder Heizleistungsdichte einer Heizzone ausgebildet. In montiertem Zustand ist unterhalb der Berührungsfläche 32 eine Touch-Bedieneinheit 14, 16 eines erfindungsgemäßen Systems angeordnet, die zu einer Detektion der mittels der Berührungsfläche 32 eingegebenen Steuerungssignale vorgesehen ist. Die Hausgerätevorrichtung 10 weist eine Steuereinheit 34 auf, die dazu vorgesehen ist, in Abhängigkeit der mittels der Berührungsfläche 32 eingegebenen Steuerungssingale Aktionen auszuführen und/oder Einstellungen zu verändern. Die Steuereinheit 34 ist mit der Touch-Bedieneinheit 14, 16 elektrisch verbunden.

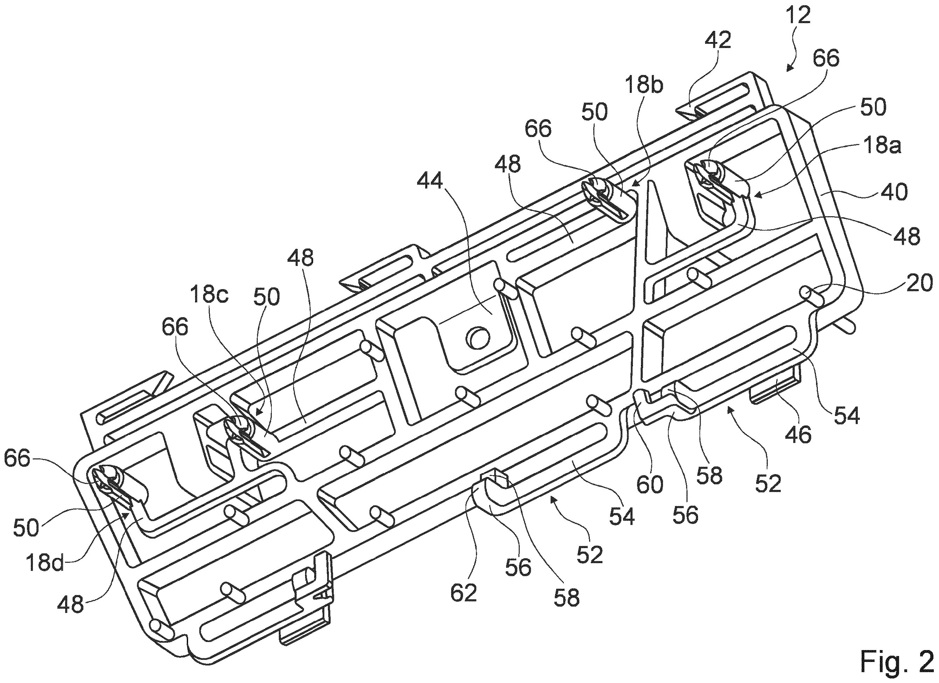

Das erfindungsgemäße System umfasst eine erste Touch-Bedieneinheit 14 eines ersten Typs und eine zweite Touch-Bedieneinheit 16 eines zweiten Typs (vgl. Fig. 2). Jede der Touch-Bedieneinheiten 14, 16 umfasst eine Platine 36, 38. Die erste Platine 36 der ersten Touch-Bedieneinheit 14 weist eine Größe von im Wesentlichen 120 x 50 x 5 mm³ auf. Die erste Touch-Bedieneinheit 14 weist zehn Infrarotsensoren 22 auf, die zu einer Detektion der Steuerungssignale vorgesehen sind. Die Infrarotsensoren 22 sind auf der ersten Platine 36 verteilt angeordnet. Die erste Touch-Bedieneinheit 14 weist eine Masse von im Wesentlichen 25 g auf. Die zweite Platine 38 der zweiten Touch-Bedieneinheit 16 weist eine Größe von im Wesentlichen 180 x 65 x 10 mm³ auf. Die zweite Touch-Bedieneinheit 16 weist dreiundzwanzig kapazitive Sensoren 24 auf, die zu einer Detektion der Steuerungssignale vorgesehen sind. Die kapazitiven Sensoren 24 sind auf der zweiten Platine 38 verteilt angeordnet. Die zweite Touch-Bedieneinheit 16 weist eine Masse von im Wesentlichen 50 g auf.

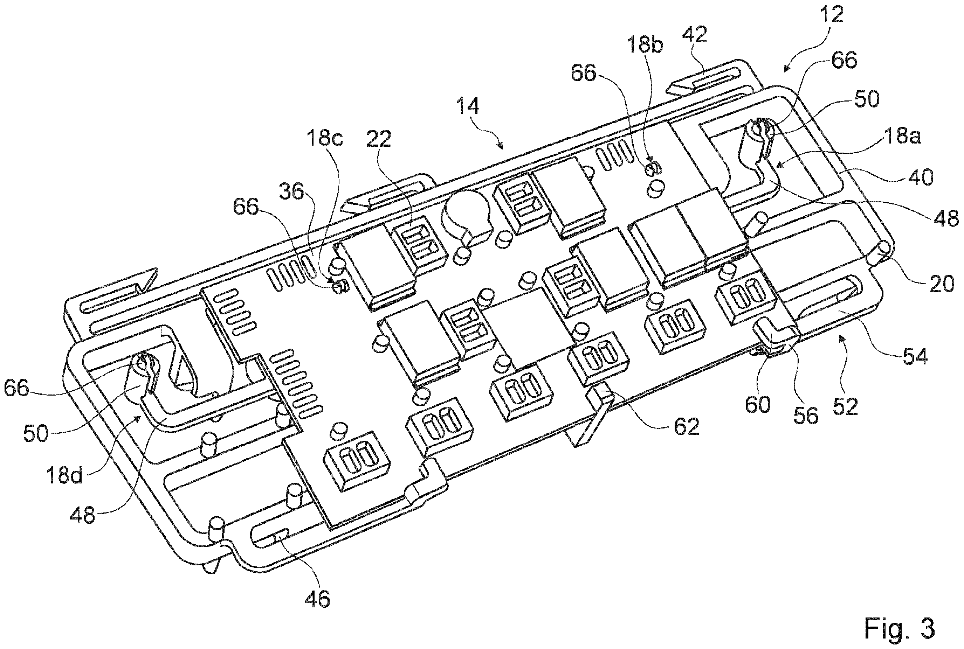

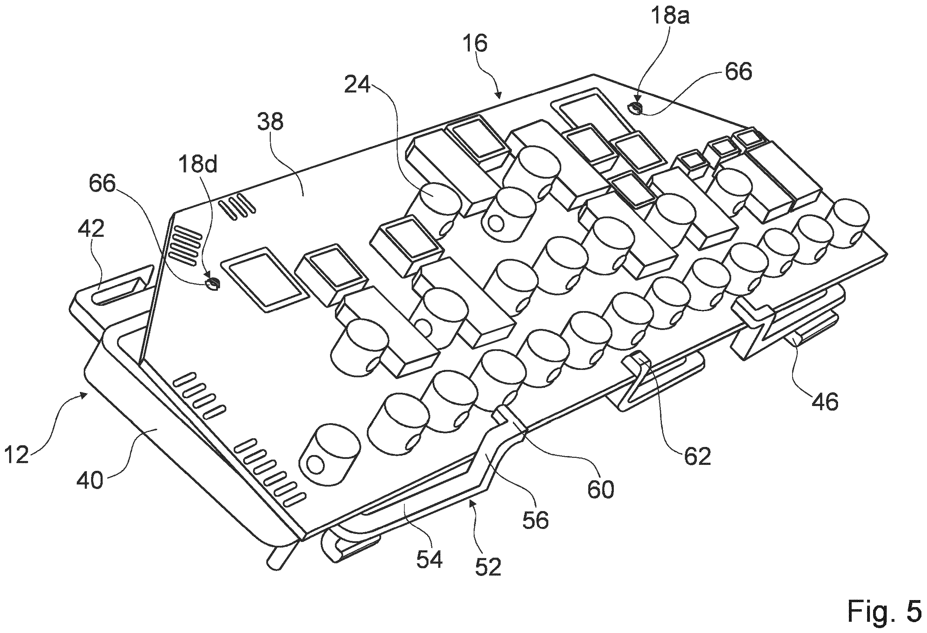

Das erfindungsgemäße System zu einer Zusammenstellung der Hausgerätevorrichtung 10 umfasst einen Grundkörper 12 (vgl. Fig. 2). Der Grundkörper 12 des Systems ist ein Teil der Hausgerätevorrichtung 10 für das erfindungsgemäße System. Der Grundkörper 12 ist aus Kunststoff ausgebildet und umfasst einen Hauptkörper 40, der einen Großteil einer Masse des Grundkörpers 12 ausbildet. Der Hauptkörper 40 weist eine Größe von im Wesentlichen 170 x 70 x 30 mm³ auf. Der Hauptkörper 40 spannt mit einer in montiertem Zustand der Platteneinheit 28 zuweisenden Oberfläche eine Hauptkörperebene auf. Der Grundkörper 12 weist in einem in montiertem Zustand einem Bediener abweisenden Bereich drei Führungselemente 42 zu einer Führung von elektrischen Verbindungen auf. Die Führungselemente 42 sind einstückig an den Hauptkörper 40 angebunden. Die Führungselemente 42 sind auf einer in montiertem Zustand von der Platteneinheit 28 abweisenden Seite der Hauptkörperebene angeordnet. Der Grundkörper 12 umfasst ein Befestigungselement 44 zu einer Befestigung des Grundkörpers 12 an einem Außengehäuse 64 der Hausgerätevorrichtung 10 (vgl. Fig. 3 und Fig. 5). Das Befestigungselement 44 ist auf einer in montiertem Zustand von der Platteneinheit 28 abweisenden Seite des Hauptkörpers 40 einstückig an den Hauptkörper 40 angebunden. Hierbei ist das Befestigungselement 44 zu einer Befestigung des Grundkörpers 12 an einer Bodenseite des Außengehäuses 64 vorgesehen. Das Befestigungselement 44 weist eine Befestigungsausnehmung zu einer Aufnahme eines Befestigungsmittels, beispielsweise einer Schraube, auf, mittels dessen der Grundkörper 12 in montiertem Zustand an dem Außengehäuse 64 befestigt ist. Der Grundkörper 12 umfasst zwei Verbindungselemente 46 zu einer Befestigung des Grundkörpers 12 an dem Außengehäuse 64. Die Verbindungselemente 46 sind auf einer in montiertem Zustand einem Bediener zuweisenden vorderen Seite des Hauptkörpers 40 einstückig an den Hauptkörper 40 angebunden. Hierbei sind die Verbindungselemente 46 zu einer Verbindung des Grundkörpers 12 mit einer Seitenwand des Außengehäuses 64 vorgesehen.

In montiertem Zustand ist eine der Touch-Bedieneinheiten 14, 16 von dem Grundkörper 12 gehalten. Die von dem Grundkörper 12 gehaltene Touch-Bedieneinheit 14, 16 wird auf den Grundkörper 12 aufgelegt. Der Grundkörper 12 ist dazu vorgesehen, in Abhängigkeit von einem Typ der von dem Grundkörper 12 gehaltenen Touch-Bedieneinheit 14, 16 die Touch-Bedieneinheit 14, 16 unterschiedlich hart zu federn. Aufgrund der unterschiedlichen Massen der Touch-Bedieneinheiten 14, 16 wirkt auf den Grundkörper 12 in Abhängigkeit von einem Typ der von dem Grundkörper 12 gehaltenen Touch-Bedieneinheit 14, 16 eine unterschiedliche Gewichtskraft ein. Eine von dem Grundkörper 12 aufzubringende Kraft zu einem Halten der ersten Touch-Bedieneinheit 14 ist um einen Faktor 900 kleiner als eine von dem Grundkörper 12 aufzubringende Kraft zu einem Halten der zweiten Touch-Bedieneinheit 16.

Der Grundkörper 12 weist vier Federelemente 18a, 18b, 18c, 18d auf. Die Federelemente 18a, 18b, 18c, 18d sind in montiertem Zustand in einem von einem Bediener abgewandten Bereich des Grundkörpers 12 angeordnet. Die Federelemente18a, 18b, 18c, 18d sind einstückig an dem Grundkörper 12 angeformt. Die Federelemente 18a, 18b, 18c, 18d sind im Wesentlichen gleichmäßig über eine Längserstreckung des Grundkörpers 12 verteilt angeordnet. Ein erstes Federelement 18a der vier Federelemente 18a, 18b, 18c, 18d ist an einem ersten Ende des Grundkörpers 12 angeordnet. Ein viertes Federelement 18d der vier Federelemente 18a, 18b, 18c, 18d ist bezüglich der Längserstreckung des Grundkörpers 12 an einem dem ersten Federelement 18a gegenüberliegenden Ende des Grundkörpers 12 angeordnet. Ein zweites Federelement 18b und ein drittes Federelement 18c der vier Federelemente 18a, 18b, 18c, 18d sind bezüglich der Längserstreckung des Grundkörpers 12 zwischen dem ersten Federelement 18a und dem vierten Federelement 18d angeordnet.

Jedes Federelement 18a, 18b, 18c, 18d umfasst einen im Wesentlichen parallel zu der Hauptkörperebene ausgerichteten Federarm 48. Jeder Federarm 48 ist in unbelastetem Zustand im Wesentlichen in der Hauptkörperebene angeordnet. Jeder Federarm 48 weist eine Größe von im Wesentlichen 30 x 5 x 3 mm³ auf. Jedes Federelement 18a, 18b, 18c, 18d weist ein erstes Kontaktelement 50 und ein zweites Kontaktelement 66 auf. Die Kontaktelemente 50, 66 sind im Wesentlichen einstückig ausgebildet. Alternativ ist denkbar, dass das erste Kontaktelement und das zweite Kontaktelement lösbar miteinander verbunden sind, beispielsweise mittels einer Rastverbindung und/oder einer Klemmverbindung. Die ersten Kontaktelemente 50 sind jeweils in direktem Kontakt mit den Federarmen 48 angeordnet. Die ersten Kontaktelemente 50 sind im Wesentlichen zwischen den Federarmen 48 und den zweiten Kontaktelementen 66 angeordnet. Die Kontaktelemente 50, 66 sind in unbelastetem Zustand im Wesentlichen senkrecht zu der Hauptkörperebene ausgerichtet. Die Kontaktelemente 50, 66 sind an einem dem Hauptkörper 40 abweisenden Ende an den Federarm 48 angebunden, insbesondere einstückig. Die Kontaktelemente 50, 66 überragen die Hauptkörperebene in einer im Wesentlichen senkrecht zu der Hauptkörperebene ausgerichteten Richtung in unbelastetem Zustand um eine Strecke von im Wesentlichen 15 mm. Somit überragt jedes Federelement 18a, 18b, 18c, 18d die Hauptkörperebene in einer im Wesentlichen senkrecht zu der Hauptkörperebene ausgerichteten Richtung in unbelastetem Zustand um eine Strecke von im Wesentlichen 15 mm. Jedes Federelement 18a, 18b, 18c, 18d weist einen Durchmesser von im Wesentlichen 6 mm auf.

Der Grundkörper 12 weist drei weitere Federelemente 52 auf, die in einem in montiertem Zustand einem Bediener zuweisenden Bereich des Grundkörpers 12 an den Hauptkörper 40 einstückig angebunden sind. Jedes weitere Federelement 52 weist einen weiteren Federarm 54 sowie ein weiteres Kontaktelement 56 auf. Das weitere Kontaktelement 56 bildet in einem dem weiteren Federarm 54 abweisenden Bereich eine Kontaktfläche 58 aus, auf der die von dem Grundkörper 12 gehaltene Touch-Bedieneinheit 14, 16 in montiertem Zustand aufgelegt ist. Zwei der weiteren Federelemente 52 weisen ein Halteelement 60 auf, das sich an die Kontaktfläche 58 anschließt und die Kontaktfläche 58 in einer von dem weiteren Federarm 56 abweisenden Richtung überragt. Jedes Halteelement 60 bildet zusammen mit der korrespondieren Kontaktfläche 58 eine Aufnahme aus, in die die von dem Grundkörper 12 gehaltene Touch-Bedieneinheit 14, 16 in montiertem Zustand eingelegt ist. Hierbei ist die von dem Grundkörper 12 gehaltene Touch-Bedieneinheit 14, 16 in einer von dem Hauptkörper 40 wegweisenden Richtung in direktem Kontakt mit den Halteelementen 60 und in einer dem Hauptkörper 40 zuweisenden Richtung in direktem Kontakt mit den Kontaktflächen 58 angeordnet. Zwei der weiteren Federelemente 52 umgreifen die von dem Grundkörper 12 gehaltene Touch-Bedieneinheit 14, 16 in montiertem Zustand. Zwei der weiteren Federelemente 52 begrenzen einen Freiheitsgrad einer Bewegung der von dem Grundkörper 12 gehaltenen Touch-Bedieneinheit 14, 16 in vertikaler Richtung, die im Wesentlichen senkrecht zu der Hauptkörperebene ausgerichtet ist. Eines der weiteren Federelemente 52 weist ein Fixierelement 62 auf, das sich an die Kontaktfläche 58 anschließt und die Kontaktfläche 58 in einer von dem weiteren Federarm 54 abweisenden Richtung überragt. Das Fixierelement 62 ragt in montiertem Zustand durch eine Öffnung in der Platine 36, 38 der von dem Grundkörper 12 gehaltenen Touch-Bedieneinheit 14, 16 hindurch. Das Fixierelement 62 beschränkt in montiertem Zustand eine seitliche Bewegung der von dem Grundkörper 12 gehaltenen Touch-Bedieneinheit 14, 16. Eines der weiteren Federelemente 52 begrenzt einen Freiheitsgrad einer Bewegung der von dem Grundkörper 12 gehaltenen Touch-Bedieneinheit 14, 16 in horizontaler Richtung, die im Wesentlichen parallel zu der Hauptkörperebene ausgerichtet ist.

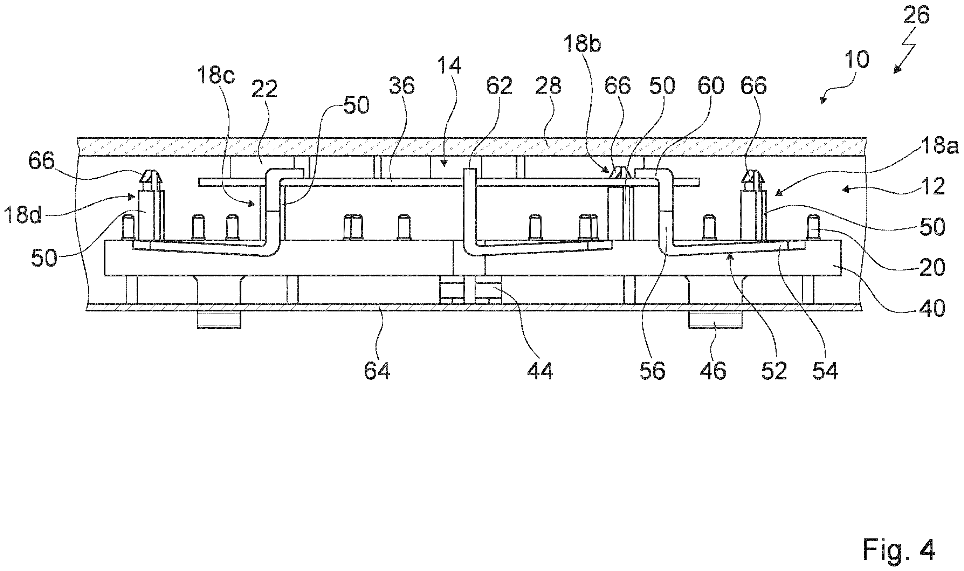

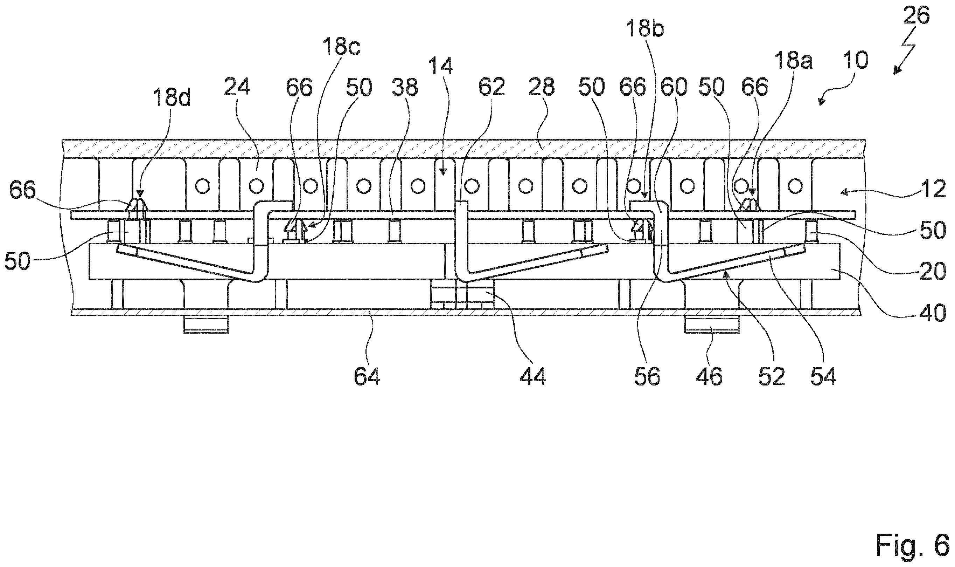

Der Grundkörper 12 weist zwölf Abstandselemente 20 auf. Die Abstandselemente 20 sind einstückig an den Grundkörper 12 angebunden. Hierbei sind die Abstandselemente 20 einstückig an den Hauptkörper 40 angebunden und unbeweglich zu dem Hauptkörper 40 angeordnet. Jedes Abstandselement 20 überragt die Hauptkörperebene in einer im Wesentlichen senkrecht zu der Hauptkörperebene ausgerichteten Richtung in unbelastetem Zustand um eine Strecke von im Wesentlichen 5 mm. Jedes Abstandselement 20 weist einen Durchmesser von im Wesentlichen 3 mm auf. Die Abstandselemente 20 definieren in montiertem Zustand einen minimalen Abstand einer von dem Grundkörper 12 gehaltenen Touch-Bedieneinheit 14, 16 von der Hauptkörperebene. In Abhängigkeit einer von dem Grundkörper 12 gehaltenen Touch-Bedieneinheit 14, 16 variiert der Abstand der von dem Grundkörper 12 gehaltenen Touch-Bedieneinheit 14, 16 von der Hauptkörperebene. Eine in Fig. 1 dargestellte Schnittlinie IV, VI - IV, VI verweist einerseits auf Fig. 4, in welcher die erste Touch-Bedieneinheit 14 von dem Grundkörper 12 gehalten ist, und andererseits auf Fig. 6, in welcher die zweite Touch-Bedieneinheit 16 von dem Grundkörper 12 gehalten ist.

Die weiteren Federelemente 52 und die Federelemente 18a, 18b, 18c, 18d sind dazu vorgesehen, in montiertem Zustand die erste Touch-Bedieneinheit 14 federnd bezüglich dem Grundkörper 12 zu lagern (vgl. Fig. 3 und Fig. 4). Die erste Touch-Bedieneinheit 14 liegt in montiertem Zustand auf dem zweiten Federelement 18b, dem dritten Federelement 18c und den weiteren Federelementen 52 auf. Das zweite und das dritte Federelement 18b, 18c greifen in montiertem Zustand teilweise durch die erste Touch-Bedieneinheit 14 hindurch. Die erste Touch-Bedieneinheit 14 liegt in montiertem Zustand direkt auf den ersten Kontaktelementen 50 des zweiten und des dritten Federelements 18b, 18c auf. Die Platine 36 der ersten Touch-Bedieneinheit 14 weist zwei Ausnehmungen zu einer Aufnahme der zweiten Kontaktelemente 66 des zweiten und des dritten Federelements 18b, 18c auf. Die zweiten Kontaktelemente 66 des zweiten und des dritten Federelements 18b, 18c greifen in montiertem Zustand durch die erste Touch-Bedieneinheit 14 hindurch. Die von dem Grundkörper 12 gehaltene erste Touch-Bedieneinheit 14 weist einen Abstand von im Wesentlichen 15 mm von der Hauptkörperebene auf. Eine von den Federelementen 18, 52 aufgebrachte Kraft ist ausreichend, um die erste Touch-Bedieneinheit 14 in direktem Kontakt mit der Platteneinheit 28 zu lagern. Eine Anpresskraft, mittels der die erste Touch-Bedieneinheit 14 in direktem Kontakt mit der Platteneinheit 28 gelagert wird, ist von den Federelementen 18, 52 des Grundkörpers 12 erzeugt. Aufgrund eines geringen Gewichts der ersten Touch-Bedieneinheit 14 und aufgrund einer geringen Anpresskraft der ersten Touch-Bedieneinheit 14 an der Platteneinheit 28 sind die Federelemente 18, 52 leicht ausgelenkt.

Die zweite Touch-Bedieneinheit 16 weist eine um einen Faktor 2 größere Gewichtskraft auf als die erste Touch-Bedieneinheit 14. Zudem ist eine von dem Grundkörper 12 aufzubringende Anpresskraft für die zweite Touch-Bedieneinheit 16 um eine Faktor 900 größer als eine von dem Grundkörper 12 aufzubringende Anpresskraft für die erste Touch-Bedieneinheit 14. Ist die zweite Touch-Bedieneinheit 16 von dem Grundkörper 12 gehalten, so sind das zweite Federelement 18b, das dritte Federelement 18c und die weiteren Federelemente 52 maximal ausgelenkt (vgl. Fig. 5 und Fig. 6). Das zweite Federelement 18b, das dritte Federelement 18c und die weiteren Federelemente 52 sind in montiertem Zustand von der durch den Grundkörper 12 gehaltenen zweiten Touch-Bedieneinheit 16 bis auf eine Höhe der Abstandselemente 20 ausgelenkt. Die zweite Touch-Bedieneinheit 16 lenkt in montiertem Zustand die zweiten Kontaktelemente 66 des zweiten und des dritten Federelements 18b, 18c bis auf eine Höhe der Abstandselemente 20 aus. Die zweite Touch-Bedieneinheit 16 lenkt in montiertem Zustand die ersten Kontaktelemente 50 des ersten und des vierten Federelements 18a, 18d bis auf eine Höhe der Abstandselemente 20 aus. Das erste und das vierte Federelement 18a, 18d greifen in montiertem Zustand teilweise durch die zweite Touch-Bedieneinheit 16 hindurch. Die zweite Touch-Bedieneinheit 16 liegt in montiertem Zustand direkt auf den ersten Kontaktelementen 50 des ersten und des vierten Federelements 18a, 18d auf. Die Platine 38 der zweiten Touch-Bedieneinheit 16 weist zwei Ausnehmungen zu einer Aufnahme der zweiten Kontaktelemente 66 des ersten und des vierten Federelements 18a, 18d auf.

Die zweite Touch-Bedieneinheit 16 weist in montiertem Zustand einen Abstand von im Wesentlichen 5 mm von der Hauptkörperebene auf. Die Abstandselemente 20 tragen in montiertem Zustand eine Gewichtskraft der zweiten Touch-Bedieneinheit 16 größtenteils. Die von dem Grundkörper 12 gehaltene zweite Touch-Bedieneinheit 16 liegt in montiertem Zustand auf den Abstandselementen 20 auf. Eine Anpresskraft, mittels der die zweite Touch-Bedieneinheit 16 gegen die Platteneinheit 28 gepresst wird, ist von dem Außengehäuse 64 und der Platteneinheit 28 erzeugt.

Bei einer Montage wird zunächst die zweite Touch-Bedieneinheit 16 auf den Grundkörper 12 aufgelegt. Anschließend wird der Grundkörper 12 an dem Außengehäuse 64 befestigt. Das Außengehäuse 64 wird mit dem an dem Außengehäuse 64 befestigten Grundkörper 12 an der Platteneinheit 28 befestigt, wodurch die von dem Grundkörper 12 gehaltene zweite Touch-Bedieneinheit 16 gegen die Platteneinheit 28 gepresst wird. Eine durch eine Befestigung des Außengehäuses 64 an der Platteneinheit 28 aufgebrachte Anpresskraft presst die zweite Touch-Bedieneinheit 16 gegen die Platteneinheit 28. Dabei werden die kapazitiven Sensoren 24 der zweiten Touch-Bedieneinheit 16 gegen die Platteneinheit 28 gepresst und an der Platteneinheit 28 aufgrund der hohen Anpresskraft verformt. Der Grundkörper 12 leitet eine von der zweiten Touch-Bedieneinheit 16 kommende Kraft an das Außengehäuse 64 weiter.

### Bezugszeichen

- 10: Hausgerätevorrichtung
- 12: Grundkörper
- 14: Erste Touch-Bedieneinheit
- 16: Zweite Touch-Bedieneinheit
- 18: Federelement
- 20: Abstandselement
- 22: Infrarotsensor
- 24: Kapazitiver Sensor
- 26: Hausgerät
- 28: Platteneinheit
- 30: Heizeinheit
- 32: Berührungsfläche
- 34: Steuereinheit
- 36: Erste Platine
- 38: Zweite Platine
- 40: Hauptkörper
- 42: Führungselement
- 44: Befestigungselement
- 46: Verbindungselement
- 48: Federarm
- 50: Erstes Kontaktelement
- 52: Weiteres Federelement
- 54: Weiterer Federarm
- 56: Weiteres Kontaktelement
- 58: Kontaktfläche
- 60: Halteelement
- 62: Fixierelement
- 64: Außengehäuse

## Patentansprüche

1. System zu einer Zusammenstellung zumindest einer Hausgerätevorrichtung (10), insbesondere einer Kochfeldvorrichtung, das zumindest einen Grundkörper (12), zumindest eine erste Touch-Bedieneinheit (14) eines ersten Typs und zumindest eine zweite Touch-Bedieneinheit (16) eines zweiten Typs aufweist, wobei zumindest in montiertem Zustand zumindest eine der Touch-Bedieneinheiten (14, 16) von dem Grundkörper (12) gehalten ist, wobei der Grundkörper (12) dazu vorgesehen ist, in Abhängigkeit von einem Typ der von dem Grundkörper (12) gehaltenen Touch-Bedieneinheit (14, 16) die Touch-Bedieneinheit (14, 16) unterschiedlich hart zu federn, wobei der Grundkörper (12) dazu vorgesehen ist, die erste Touch-Bedieneinheit (14) des ersten Typs mit einer ersten Federkonstanten bezüglich des Grundkörpers (12) zu lagern und die zweite Touch-Bedieneinheit (16) des zweiten Typs mit einer zweiten Federkonstanten, die größer als die erste Federkonstante ist, bezüglich des Grundkörpers (12) zu lagern, **dadurch gekennzeichnet, dass** eine von dem Grundkörper (12) aufzubringende Kraft zu einem Halten der ersten Touch-Bedieneinheit (14) zumindest um einen Faktor 20 kleiner ist als eine von dem Grundkörper (12) aufzubringende Kraft zu einem Halten der zweiten Touch-Bedieneinheit (16), wobei die erste Touch-Bedieneinheit (14) zumindest einen Infrarotsensor (22) aufweist und die zweite Touch-Bedieneinheit (16) zumindest einen kapazitiven Sensor (24) aufweist.

2. System nach Anspruch 1, **dadurch gekennzeichnet, dass** der Grundkörper (12) zumindest ein Federelement (18) aufweist, das dazu vorgesehen ist, zumindest in montiertem Zustand zumindest die erste Touch-Bedieneinheit (14) federnd bezüglich dem Grundkörper (12) zu lagern.

3. System nach Anspruch 2, **dadurch gekennzeichnet, dass** das Federelement (18) einstückig an dem Grundkörper (12) angebunden ist.

4. System nach einem der vorhergehenden Ansprüche, **dadurch gekennzeichnet, dass** der Grundkörper (12) zumindest ein Abstandselement (20) aufweist, das dazu vorgesehen ist, zumindest in montiertem Zustand eine Gewichtskraft zumindest der zweiten Touch-Bedieneinheit (16) zumindest größtenteils zu tragen.

5. System nach den Ansprüchen 2 und 4, **dadurch gekennzeichnet, dass** das Federelement (18) zumindest in montiertem Zustand von der durch den Grundkörper (12) gehaltenen zweiten Touch-Bedieneinheit (16) bis auf eine Höhe des Abstandselements (20) ausgelenkt ist.

## Claims

1. A system for assembling at least one household appliance device (10), in particular a hob device, which has at least one base body (12), at least one first touch control unit (14) of a first type and at least one second touch control unit (16) of a second type, wherein at least in the mounted state at least one of the touch control units (14, 16) is held by the base body (12), wherein the base body (12) is provided to cushion the touch control unit (14, 16) to differing degrees as a function of a type of the touch control unit (14, 16) held by the base body (12), wherein the base body (12) is provided to support the first touch control unit (14) of the first type with a first spring constant with respect to the base body (12) and to support the second touch control unit (16) of the second type with a second spring constant, which is larger than the first spring constant, with respect to the base body (12), **characterized in that** a force to be applied by the base body (12) for holding the first touch control unit (14) is smaller at least by a factor of 20 than a force to be applied by the base body (12) for holding the second touch control unit (16), wherein the first touch control unit (14) has at least one infrared sensor (22) and the second touch control unit (16) has at least one capacitive sensor (24).

2. The system as claimed in claim 1, **characterized in that** the base body (12) has at least one spring element (18), which is provided to support, at least in the mounted state, at least the first touch control unit (14) in a resilient manner with respect to the base body (12).

3. The system as claimed in claim 2, **characterized in that** the spring element (18) is bound in one piece on the base body (12).

4. The system as claimed in one of the preceding claims, **characterized in that** the base body (12) has at least one spacer element (20), which is provided, at least in the mounted state, to at least largely support a weight force of at least the second touch unit (16).

5. The system as claimed in claims 2 and 4, **characterized in that** the spring element (18), at least in the mounted state, is deflected from the second touch control unit (16) held by the base body (12) up to a height of the spacer element (20).

## Revendications

1. Système pour un assemblage d'au moins un dispositif d'appareil ménager (10), en particulier d'un dispositif de champ de cuisson, qui présente au moins un corps de base (12), au moins une première unité de commande tactile (14) d'un premier type et au moins une deuxième unité de commande tactile (16) d'un deuxième type, dans lequel au moins à l'état monté au moins une des unités de commande tactiles (14, 16) est maintenue par le corps de base (12), dans lequel le corps de base (12) est prévu, en fonction d'un type de l'unité de commande tactile (14, 16) maintenue par le corps de base (12), afin de recevoir élastiquement l'unité de commande tactile (14, 16) selon une dureté différente, dans lequel le corps de base (12) est prévu afin de loger la première unité de commande tactile (14) du premier type selon une première constante de rappel par rapport au corps de base (12) et la deuxième unité de commande tactile (16) du deuxième type selon une deuxième constante de rappel, qui est supérieure à la première constante de rappel, par rapport au corps de base (12), **caractérisé en ce qu'**une force à appliquer par le corps de base (12) pour un maintien de la première unité de commande tactile (14) est au moins inférieure d'un facteur 20 à une force à appliquer par le corps de base (12) pour un maintien de la deuxième unité de commande tactile (16), dans lequel la première unité de commande tactile (14) présente au moins un capteur infrarouge (22) et la deuxième unité de commande tactile (16) présente au moins un capteur capacitif (24).

2. Système selon la revendication 1, **caractérisé en ce que** le corps de base (12) présente au moins un élément à ressort (18) prévu afin de loger au moins à l'état monté au moins la première unité de commande tactile (14) élastiquement par rapport au corps de base (12).

3. Système selon la revendication 2, **caractérisé en ce que** l'élément à ressort (18) est relié en une seule pièce au corps de base (12).

4. Système selon l'une des revendications précédentes, **caractérisé en ce que** le corps de base (12) présente au moins un élément d'écartement (20) prévu afin de porter, au moins à l'état monté, au moins en majeure partie un poids d'au moins la deuxième unité de commande tactile (16).

5. Système selon les revendications 2 et 4, **caractérisé en ce que** l'élément à ressort (18) est, au moins à l'état monté, dévié par le deuxième élément de commande tactile (16) maintenu par le corps de base (12) jusqu'à une hauteur de l'élément d'écartement (20).
